# EUROPÄISCHE PATENTSCHRIFT

(11) **EP 1 405 399 B1**
(45) Veröffentlichungstag und Bekanntmachung des Hinweises auf die Patenterteilung: **05.01.2005**
(21) Anmeldenummer: 02752972.6
(22) Anmeldetag: 21.06.2002
(51) Int. Cl.: H03D 3/00

(54) **EMPFÄNGERANORDNUNG MIT WECHSELSTROM-KOPPLUNG**
RECEIVER DEVICE COMPRISING AN ALTERNATING CURRENT COUPLING
DISPOSITIF DE RECEPTION A COUPLAGE COURANT ALTERNATIF

(30) Priorität: 29.06.2001 DE 10131676
(43) Veröffentlichungstag der Anmeldung: 07.04.2004
(73) Patentinhaber: Infineon Technologies AG, 81669 München (DE)
(72) Erfinder: ADLER, Bernd, Plainsboro, NJ 08536 (US); PIMINGSDORFER, Dieter, A-4020 Linz (AT); PRETL, Harald, A-4311 Schwertberg (AT); SCHELMBAUER, Werner, A-4040 Linz (AT)
(74) Vertreter: Epping Hermann & Fischer
(86) Internationale Anmeldenummer: PCT/DE2002/002266
(87) Internationale Veröffentlichungsnummer: WO 2003/005593

(56) Entgegenhaltungen:
- EP-A- 0 255 175
- EP-A- 0 948 128
- WO-A-97/29552
- WO-A-98/38799
- DE-A- 19 810 558

## Beschreibung

Die vorliegende Erfindung betrifft eine Empfängeranordnung mit Wechselstrom-Kopplung.

Bei Mobilfunk-Empfängern werden homodyne und heterodyne Architekturen unterschieden. Während bei heterodynen Mobilfunkempfängern ein empfangenes Hochfrequenzsignal zunächst in eine Zwischenfrequenz umgesetzt wird, um anschließend ins Basisband konvertiert zu werden, setzen homodyne Mobilfunkempfänger das Hochfrequenzsignal in lediglich einem Umsetzungsschritt in das Basisband um. Derartige, homodyne Mobilfunkempfänger werden auch als Zero-IF oder als Direct Conversion(DC)-Receiver bezeichnet und kommen beispielsweise beim sogenannten Mobilfunkstandard der dritten Generation, Universal Mobile Telecommunications System, UMTS, zum Einsatz.

Ein systembedingter Nachteil der Direktumsetzung sind Gleichspannungsoffsets, welche zum einen statisch und zum anderen dynamischer Natur sein können. Die statischen Offsets sind unter anderem auf schaltungstechnisch bedingte Offsets in den einzelnen Blöcken der Empfängerketten zurückzuführen, beispielsweise große Paarungstoleranzen der Bauelemente.

Bei schwachem Empfangssignal, das heißt, daß die beschriebenen DC-Offsets um ein Vielfaches höher als das eigentliche Nutzsignal sein können, werden die Offsets mit der für das Nutzsignal erforderlichen Verstärkung im Basisband mitverstärkt, so daß am Ausgang der analogen Basisbandkette und am Eingang der dort üblicherweise vorgesehenen Analog-/Digital-Konverter ein für die Digitalisierung zu großes Signal anliegen würde. Es ist deshalb unumgänglich, derartige Gleichspannungsoffsets schaltungstechnisch zu kompensieren.

Übliche Methoden zur Kompensation eines Gleichspannungsoffsets in der analogen Basisbandkette beruhen entweder auf dem Hochpaßprinzip und werden mit einfachen Wechselstrom-Kopplungen realisiert, öder es sind Rückkopplungsschleifen vorgesehen, wobei der Rückkopplungspfad Tiefpaßeigenschaften hat (siehe z,B WO 01/24352).

Insgesamt haben diese Methoden den Nachteil, daß einerseits eine niedrige Grenzfrequenz des Hochpasses gefordert ist, um das Nutzsignal nicht zu stark zu verzerren, andererseits jedoch eine hohe Grenzfrequenz gefordert ist, damit die Einschwingzeit der Wechselstrom-Kopplung nicht zu groß wird. Zudem ist bei vielen Direktumsetzern eine adaptive Verstärkungsregelung vorgesehen, die von der Empfangsfeldstärke des Hochfrequenzsignals abhängig ist. Derartige Verstärkungsregelungen bringen jedoch sprunghafte Änderungen der Verstärkung mit sich, wodurch transiente Ausgleichsvorgänge bedingt sind, die das Nutzsignal um ein Vielfaches übersteigen können, so daß der Analog-/Digital-Wandler nicht ideal ausgesteuert werden kann.

Die beschriebene Problematik der transienten Ausgleichsvorgänge aufgrund von Änderungen der Verstärkungsfaktoren werden dadurch verschärft, daß derartige Transienten durch nachfolgende Verstärkerstufen, beispielsweise programmierbare Verstärker, noch um ein Vielfaches verstärkt würden.

Bei Mobilfunkverfahren wie GSM, welche mit Zeitvielfachzugriff, TDMA, Time Division Multiple Access, arbeiten und demnach in Zeitschlitzen senden und empfangen, können die geschilderten Probleme dadurch umgangen werden, daß Änderungen der Verstärkung nur zwischen Zeitschlitzen erfolgen. Bei Mobilfunkverfahren, bei denen ein kontinuierliches Empfangen gefordert ist, beispielsweise bei Systemen, die mit CDMA-, Code Division Multiple Access-Verfahren arbeiten, ist es jedoch wünschenswert, auch bei einem pausenlosen Betrieb des Empfängers eine Anpassung der Verstärkung an die Empfangsfeldstärke durchzuführen.

Aufgabe der vorliegenden Erfindung ist es, eine Empfängeranordnung mit Wechselstrom-Kopplung anzugeben, bei der eine Anpassung der Verstärkung im Empfänger während eines normalen Empfangsbetriebs ermöglicht ist.

Erfindungsgemäß wird die Aufgabe gelöst mit einer Empfängeranordnung mit Wechselstrom-Kopplung, umfassend
- einen Eingang zum Zuführen eines Hochfrequenzsignals,
- einen Frequenzumsetzer, der mit dem Eingang gekoppelt ist und an seinem Ausgang ein Basisbandsignal bereitstellt,
- einen Basisband-Verstärker mit einstellbarer Verstärkung, der am Ausgang des Frequenzumsetzers angeschlossen ist und einen Steuereingang zum Einstellen der Verstärkung hat,
- eine Filteranordnung zur Wechselstrom-Kopplung, mit einem Eingang, der an einen Ausgang des Basisband-Verstärkers angeschlossen ist und mit einem Hochpaßfilter zur Filterung des Basisband-Signals, mit einer zwischen zumindest zwei Werten umschaltbaren Grenzfrequenz, wobei in einem Normalbetrieb die geringere und in einem Umschaltbetrieb die höhere der zumindest zwei Grenzfrequenzen wirksam ist, und mit einem Steuereingang zum Einstellen der Grenzfrequenz, und
- eine Steuerschaltung zum Aktivieren der höheren Grenzfrequenz während des Umschaltbetriebes aufgrund einer Nachführung der Verstärkung des Basisband-Verstärkers, an die Empfangs bedingungen mit einem Ausgang, der mit den Steuereingängen des Basisband-Verstärkers und der Filteranordnung verbunden ist.

Das Hochpaßfilter, welches zur AC-Kopplung in der Signalverarbeitungskette des Basisbands vorgesehen ist, ermöglicht mit einer kleineren Grenzfrequenz, die im Normalbetrieb eingestellt ist, von beispielsweise 2 KHz, das empfangene Nutzsignal mit großer Genauigkeit zu übertragen. Bei einem Verändern des Verstärkungsverhältnisses des Verstärkers beispielsweise bei geänderter Empfangsfeldstärke wird hingegen auf eine höhere Grenzfrequenz von beispielsweise > 1 MHz umgeschaltet, mittels derer ein schnelleres Einschwingen des Filters ermöglicht ist. Die höhere Grenzfrequenz wird dabei für ein festlegbares Zeitintervall, beispielsweise einige Mikrosekunden, aktiviert, und anschließend wieder auf die kleinere Grenzfrequenz, das heißt auf eine langsamere Zeitkonstante, umgeschaltet.

Die beschriebene Umschaltbarkeit der AC-Kopplung bezüglich der Grenzfrequenz ermöglicht damit ein Anpassen beziehungsweise Nachführen der Verstärkerleistung an die Empfangsbedingungen beispielsweise einer Mobilstation, so daß der vorliegende Empfänger für Mobilfunkverfahren geeignet ist, die nicht mit Zeitschlitzen arbeiten, sondern bei denen ein kontinuierlicher Empfangsbetrieb zu gewährleisten ist.

Das beschriebene Verändern der Verstärkung des bevorzugt rauscharm ausgebildeten Basisbandverstärkers mit einstellbarer Verstärkung erfolgt bevorzugt in einer sogenannten weichen Umschaltung, das heißt nicht mit abruptem, sprunghaften Übergang.

Da mit beschriebener Anordnung ein der Empfängeranordnung nachgeschalteter Analog-/Digital-Konverter im optimalen Arbeitspunkt angesteuert werden kann, kann dieser mit geringerem Aufwand und einer geringeren Auflösung aufgebaut sein.

Die beschriebene Anordnung erlaubt Änderungen der Verstärkung während des normalen Empfangsbetriebs.

In einer bevorzugten Ausführungsform der vorliegenden Erfindung ist die Steuerschaltung so ausgebildet, daß das Aktivieren der höheren Grenzfrequenz für ein einstellbares Zeitintervall erfolgt, welches zum Zeitpunkt des Veränderns der Verstärkung des Basisbandverstärkers beginnt. Nach einem verändern der Verstärkung im Basisband wird für beispielsweise einige Mikrosekunden auf die höhere Grenzfrequenz umgeschaltet, um ein schnelles Einschwingen sowie einen transienten Ausgleichsvorgang mit geringer Dauer zu ermöglichen.

In einer weiteren, bevorzugten Ausführungsform der Erfindung beträgt die höhere Grenzfrequenz größer oder gleich 1 MHz.

In einer weiteren, bevorzugten Ausführungsform der vorliegenden Erfindung umfaßt die Filteranordnung ein zuschaltbares Tiefpaßfilter, welches mit der Steuerschaltung zum Aktivieren der Tiefpaßwirkung während des Umschaltbetriebes gekoppelt ist.

Das zuschaltbare Tiefpaßfilter, das dem Hochpaßfilter bevorzugt vorgeschaltet ist, vermeidet bei einem Aktivieren der höheren Grenzfrequenz einen Sampling-Effekt, der insbesondere dann auftreten kann, wenn das Nutzsignal nicht wesentlich kleiner als der vom Verstärkerumschalten verursachte Gleichspannungs-Sprung ist. Dem Hochpaßfilter mit der höheren Grenzfrequenz wird dabei während der Aktivierung der höheren Grenzfrequenz ein tiefpaßgefiltertes Basisbandsignal zugeführt. Diese Tiefpaßwirkung verringert den Sampling-Effekt insbesondere bei großen Nachbarkanälen, das heißt, wenn die Filteranordnung dem Kanalfilter im Basisband vorgeschaltet ist. Gerade am Beginn der Basisbandkette ist jedoch die beschriebene Wechselstrom-Kopplung mit der Filteranordnung notwendig, um DC-Offsets, die durch die Frequenzumsetzung auftreten und beispielsweise durch Fehlanpassungen im Mischer bedingt sind, zu eliminieren.

In einer weiteren, bevorzugten Ausführungsform der vorliegenden Erfindung ist ein programmierbarer Verstärker vorgesehen, der mit dem Ausgang des Filters gekoppelt und an die Steuerschaltung angeschlossen ist, zum Einstellen der kleinsten einstellbaren Verstärkung während des Umschaltbetriebs.

Mit der beschriebenen Aktivierung der kleinsten einstellbaren Verstärkung des programmierbaren Verstärkers kann die Unterdrückung einer durch Umschalten des Verstärkungsfaktors bedingten Transienten weiter verringert werden. Die Dauer einer derartigen Dunkeltastung des programmierbaren Verstärkers bemißt sich dabei nach der Einschwingzeit eines im Basisband vorgesehenen Kanalfilters und entspricht bevorzugt der Zeitdauer der Aktivierung der höheren Grenzfrequenz in der Filteranordnung durch die Steuerschaltung. Diese kann beispielsweise wenige Mikrosekunden betragen.

Als Alternative zur beschriebenen Dunkeltastung des programmierbaren Verstärkers können weitere Mittel zur Wechselstrom-Kopplung in die Basisbandkette eingefügt sein. Das beschriebene Einstellen der kleinsten einstellbaren Verstärkung am programmierbaren Verstärker vermeidet jedoch zusätzlichen Aufwand, da der programmierbare Verstärker üblicherweise ohnehin vorgesehen ist und ohnehin einen Steuereingang zum Einstellen oder Programmieren des Verstärkungsverhältnisses aufweist.

In einer weiteren, bevorzugten Ausführungsform der vorliegenden Erfindung ist ein Basisbandfilter vorgesehen, welches zwischen Filteranordnung und programmierbaren Verstärker geschaltet ist. Das Basisbandfilter dient insbesondere zur Kanalfilterung, das heißt zur Unterdrückung unerwünschter Nachbarkanäle.

In einer weiteren, bevorzugten Ausführungsform der vorliegenden Erfindung ist die Empfängeranordnung zur Verarbeitung symmetrischer Signale ausgelegt.

Wird dem beschriebenen Frequenzumsetzer ein Lokaloszillator-Signal zum Heruntermischen der hohen Frequenz auf die Basisbandfrequenz zum einen unverändert und zum anderen mit einer Phasenverschiebung von 90° zugeführt und ist die Basisbandkette damit zur Übertragung komplexwertiger Signale ausgelegt, so können sowohl der Inphase- als auch der Quadratur-Signalpfad jeweils als symmetrische Signalpfade ausgebildet sein. In diesem Fall ist die beschriebene Basisbandkette mit Frequenzumsetzer, rauscharmem Basisband-Verstärker mit einstellbarem Verstärkungsverhältnis, Filteranordnung, Basisband-Kanalfilter sowie programmierbarem Verstärker jeweils in I- und Q-Signalzweig vorgesehen.

In einer weiteren, bevorzugten Ausführungsform der vorliegenden Erfindung umfaßt das Hochpaßfilter der Filteranordnung einen Querzweig in einem symmetrischen Signalpfad, der einen Widerstand mit dazu parallel geschaltetem ersten Schalter aufweist. Weiterhin ist dem Querzweig jeweils ein Längszweig in den beiden zur Übertragung symmetrischer Signale ausgebildeten Leitungen vorgeschaltet, der jeweils eine Kapazität umfaßt.

Das mit Widerständen und Kapazitäten analog aufgebaute Hochpaßfilter ist somit mit dem beschriebenen ersten Schalter in einfacher Weise zwischen zwei Zeitkonstanten und damit zwischen zwei unteren Grenzfrequenzen der Hochpaßfilterung umschaltbar. Anstelle des beschriebenen können auch andere analoge Schaltungen zur Bildung eines Hochpaßfilters vorgesehen sein.

Der erste Schalter ist dabei in einem Normalbetrieb geöffnet, so daß der Widerstand im Querzweig wirksam ist und demnach eine langsame Zeitkonstante von beispielsweise 2 KHz aktiviert ist. Im Umschaltbetrieb wird der erste Schalter geschlossen, so daß eine hohe Grenzfrequenz von beispielsweise 1 MHz wirkt.

In einer weiteren, bevorzugten Ausführungsform der vorliegenden Erfindung umfassen die Längszweige des symmetrischen Signalpfads je eine Parallelschaltung aus einem Widerstand und einem zweiten Schalter, die jeweils den beschriebenen Kapazitäten in den Längszweigen vorgeschaltet sind.

Die zweiten Schalter sind in einem Normalbetrieb geschlossen, so daß mit einem Kurzschluß die Längswiderstände überbrückt sind. In einem Umschaltbetrieb hingegen werden die zweiten Schalter geöffnet, so daß die Kapazität C über den Längswiderstand Signaländerungen am Eingang folgt und damit eine Tiefpaßfilterung erzielt ist. Diese Tiefpaßfilterung vermeidet einen gegebenenfalls auftretenden Sampling-Effekt. Anstelle der beschriebenen kann auch eine andere, analog aufgebaute Tiefpaßfilterung vorgesehen sein, die dem Hochpaßfilter mit umschaltbarer Grenzfrequenz vorgeschaltet ist.

In einer weiteren, bevorzugten Ausführungsform der vorliegenden Erfindung ist die Steuerschaltung so ausgebildet, daß zum Aktivieren des Umschaltbetriebs zunächst die zweiten Schalter geöffnet und anschließend die ersten Schalter geschlossen werden und daß zur Rückkehr in den Normalbetrieb zunächst die ersten Schalter geöffnet und anschließend die zweiten Schalter geschlossen werden.

Die beschriebene Schaltreihenfolge ist zur sicheren Vermeidung des Sampling-Effekts erforderlich. Demnach wird die Tiefpaßfilterung aktiviert, bevor das Hochpaßfilter auf die höhere Grenzfrequenz umgeschaltet wird und beim Zurückschalten auf den Normalbetrieb wird zunächst auf die kleine Grenzfrequenz der Hochpaßfilterung zurückgeschaltet und erst anschließend die Tiefpaßfilterung aufgehoben.'

Weitere Einzelheiten der Erfindung sind Gegenstand der Unteransprüche.

Die Erfindung wird nachfolgend an mehreren Ausführungsbeispielen anhand der Zeichnungen näher erläutert.

Es zeigen:
- Figur 1: ein erstes Ausführungsbeispiel des Hochpaßfilters der Filteranordnung,
- Figur 2: die mit der umschaltbaren Grenzfrequenz der Anordnung gemäß Figur 1 erzielbare Verringerung von Ausgleichsvorgängen bei Änderung des Verstärkungsverhältnisses,
- Figur 3: das Einschwingverhalten einer Basisband-Signalverarbeitungskette mit einer Filteranordnung gemäß Figur 1 sowie nachgeschaltetem Kanalfilter und programmierbarem Verstärker anhand einer Sprungantwort am Ausgang des programmierbaren Verstärkers,
- Figur 4: anhand eines Signalverlaufs am Basisband-Ausgang den Sampling-Effekt, der insbesondere dann auftritt, wenn das Nutzsignal nicht wesentlich kleiner als der durch ein Umschalten der Verstärkung am Anfang der Basisbandkette auftretende DC-Sprung ist,
- Figur 5: anhand eines Beispiels eine Weiterbildung der Filteranordnung von Figur 1 mit einer zusätzlichen Tiefpaßfilterung zur Vermeidung eines Sampling-Effekts,
- Figur 6: den Signalverlauf gemäß Figur 5 in Analogie zu Figur -1,
- Figur 7: anhand eines Blockschaltbildes die Empfängeranordnung mit einer Filteranordnung beispielsweise gemäß Figuren 1 oder 5, und
- Figur 8: die Signalverläufe der Steuersignale von Basisbandverstärker, Filteranordnung und programmierbaren Verstärker gemäß dem Blockschaltbild von Figur 7.

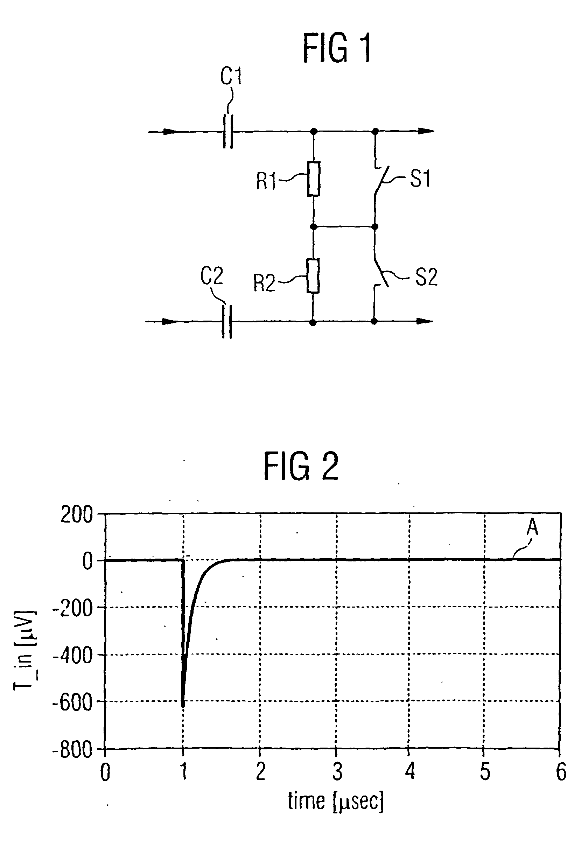

Figur 1 zeigt eine Filteranordnung zur Wechselstrom-Kopplung zur Anwendung in einem symmetrisch ausgelegten Empfänger, genauer in dessen Basisband-Signalverarbeitungskette und bevorzugt nachgeschaltet einem rauscharmen Basisband-Verstärker mit einstellbarer Verstärkung, der am Signalausgang eines Frequenzumsetzers zur Direktkonversion angeordnet ist.

Die Anordnung gemäß Figur 1 umfaßt in den beiden Längszweigen des symmetrischen Basisband-Signalpfades je eine Längs-Kapazität C1, C2. Ausgangsseitig an den Kapazitäten C1, C2 ist je ein Widerstand R1, R2 angeschlossen, wobei die Widerstände R1, R2, die in Serie miteinander verschaltet sind und einen Querzweig im Basisband-Signalpfad bilden, mit je einem weiteren Anschluß unmittelbar miteinander verbunden sind. Parallel zu den ersten Widerständen R1, R2 ist je ein erster Schalter S1, S2 angeschlossen.

Die Anordnung gemäß Figur 1 ist ein Hochpaßfilter mit umschaltbarer Grenzfrequenz, wobei die Grenzfrequenzen aus den Bauelementwerten der Kapazitäten C1, C2, den Widerständen R1, R2 sowie parasitären Elementen gebildet sind.

Die Schalter S1, S2 werden bevorzugt gleichzeitig geschaltet und sind mit einer Steuerschaltung verbunden.

Die Schaltung gemäß Figur 1 ist bevorzugt zur Anwendung in Empfängeranordnungen geeignet, die auf dem Direktumsetzungsprinzip beruhen, das heißt für homodyne Empfangsarchitekturen.

Die Schaltung gemäß Figur 1 ermöglicht dabei einen kontinuierlichen Empfangsbetrieb auch dann, wenn zur Anpassung an die Empfangsfeldstärke während des normalen Empfangsbetriebes der Verstärkungsfaktor eines der Wechselstrom-Kopplung vorgeschalteten Verstärkers verändert wird. Hierfür wird bei Verändern des Verstärkungsfaktors auf eine deutlich höhere Grenzfrequenz umgeschaltet, beispielsweise durch Schließen der Schalter S1, S2, so daß ein DC-Sprung, der durch das Umschalten der Verstärkung bedingt ist, mit einer sehr geringen Zeitkonstante abklingt. Die bei offenen Schaltern S1, S2 wirksame Grenzfrequenz des Hochpaßfilters kann dabei sehr niedrig gewählt werden, beispielsweise zu 2 KHz, so daß das Nutzsignal praktisch unverzerrt übertragen wird. Insgesamt geht bei einem Verstärkungssprung nur ein Minimum an Information des Nutzsignals verloren. Eventuell beim Umschalten der Verstärkung auftretende Transienten bleiben vernachlässigbar klein. Ein einer Basisbandkette eines Empfängers mit einer Wechselstrom-Kopplung gemäß Figur 1 nachgeschalteter Analog-/Digital-Wandler kann somit im optimalen Arbeitspunkt ausgesteuert werden, so daß der Wandler mit einer besonders geringen Anzahl an Bits zur Digitalisierung aufgebaut werden kann. Da Verstärkungssprünge während des normalen Empfangsbetriebs durchführbar sind, ist die beschriebene Wechselstrom-Kopplung für Code-Vielfachzugriffsverfahren, wie im UMTS-Standard vorgesehen, geeignet.

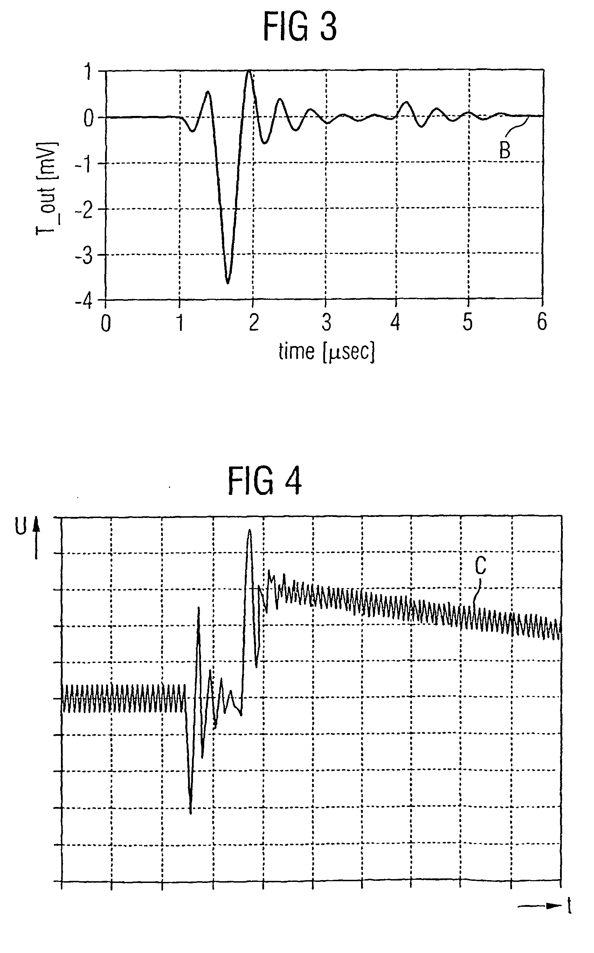

Abbildung 2 zeigt den zeitlichen Verlauf der Spannung im Mikrovolt aufgetragen über der Zeit in Mikrosekunden eines Signals A am Ausgang der Filteranordnung gemäß Figur 1, wenn an deren Eingang ein Verstärker angeordnet ist, an dem eine Veränderung der Verstärkung vorgenommen wird. Die Filteranordnung gemäß Figur 1 weist dabei eine geringe Grenzfrequenz von 2 KHz und eine hohe Grenzfrequenz von > 1 MHz auf. Der DC-Offset beträgt dabei ca. 5 mV, die Verstärkung springt von 18 dB auf 12 dB, wobei der -6 dB-Sprung des vorgeschalteten Verstärkers mit weichem Übergang erfolgt. Es ist erkennbar, daß die Einschwingzeit der Filteranordnung auf < 1 Mikrosekunde reduziert wurde und der Transient zum Schaltzeitpunkt t = lus auf 0,6 mV beschränkt ist. Ohne Umschalten der Grenzfrequenz bei einem Filter mit fester Grenzfrequenz von 4 KHz, einem DC-Offset von 5 mV und einem Spannungsverstärkungssprung von ebenfalls 18 auf 12 dB würde das Hochpaßfilter nur sehr langsam einschwingen, wobei die Einschwingzeit > 100 us läge. Weiters würde ein Transient von 20 mV entstehen, der durch nachfolgende Verstärkerstufen noch um ein Vielfaches, insgesamt bis zu 50 dB verstärkt würde.

Figur 3 zeigt die Sprungantwort B einer Empfängeranordnung mit rauscharmem Basisbandverstärker mit einstellbarer Verstärkung und nachgeschalteter Filteranordnung gemäß Figur 1, gemessen am Ausgang eines programmierbaren Verstärkers, der einem Kanalfilter nachgeschaltet ist, das wiederum am Ausgang der Filteranordnung angeschlossen ist. Dabei ist erkennbar, daß die Einschwingzeit dieser gesamten Basisbandkette bei einem Verändern des Verstärkungsfaktors des Basisbandverstärkers am Eingang der Basisbandkette beschränkt ist auf zirka 3 Mikrosekunden und der dabei maximal auftretende Transient, der 4 mV nicht übersteigt, annähernd vernachlässigt werden kann.

Figur 4 zeigt die Signalverhältnisse anhand eines Signalverlaufs C in dem Fall, wenn das eigentliche Nutzsignal nicht deutlich kleiner als der vom Umschalten der Verstärkung verursachte DC-Sprung ist. Während des Umschaltbetriebs, das heißt, daß die Schalter S1, S2 gemäß Figur 1 geschlossen sind und dadurch die hohe Grenzfrequenz im Hochpaßfilter wirkt, folgt die Spannung an Kondensatoren C1, C2 dem Eingangssignal. Beim Umschalten zurück in den Normalbetrieb durch Öffnen der Schalter S1, S2 kommt es in diesem Fall zu einem Sampling-Effekt, das heißt, daß das aktuelle Signal an den Kondensatoren C1, C2 abgetastet und mit der nun wieder eingestellten großen Zeitkonstante des Normalbetriebs, das heißt mit der Grenzfrequenz von 2 KHz, abklingt. Solche Verhältnisse können vor allem am Beginn der Basisbandkette auftreten, wo einerseits eine Wechselstrom-Kopplung notwendig ist, da die Frequenzumsetzer zum Umsetzen der Hochfrequenz in das Basisband herstellungsbedingte DC-Offsets aufweisen, andererseits aber Nachbarkanäle noch ungefiltert vorhanden sind, da die Wechselstrom-Kopplung unmittelbar am Ausgang der Mischer und damit noch vor dem Kanalfilter im Basisband erfolgt. Figur 4 beschreibt diese Signalspannung in Abhängigkeit von der Zeit am Ausgang der Basisbandkette, das heißt nach dem programmierbaren Verstärker und vor Analog-/Digital-Wandlern.

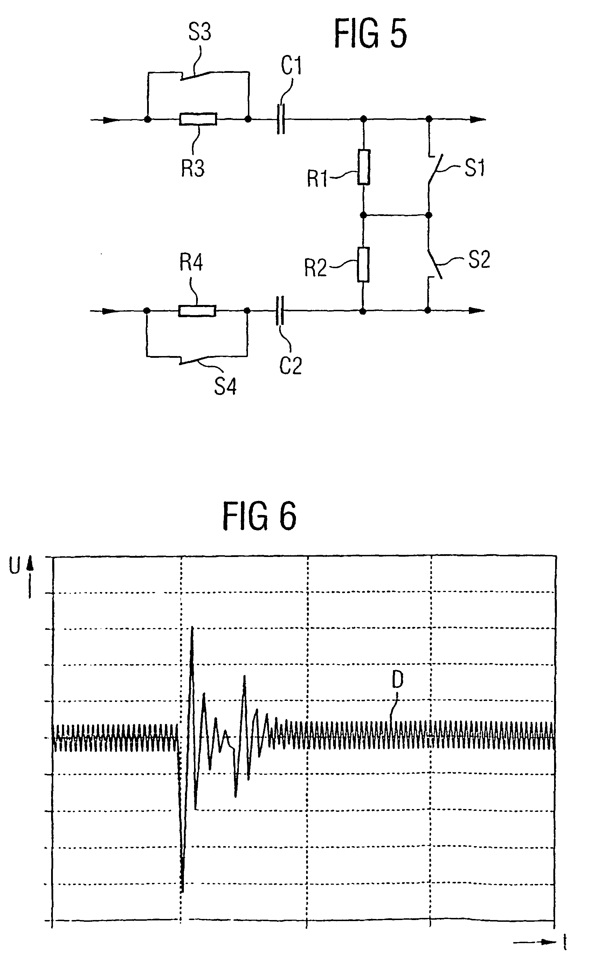

Figur 5 zeigt eine bezüglich Figur 1 weitergebildete Filteranordnung, welche zusätzlich zum Hochpaß R1, R2, C1, C2 mit umschaltbarer Grenzfrequenz einen diesem Hochpaß vorgeschalteten, zuschaltbaren Tiefpaß R3, C1; R4, C2 aufweist. Dabei ist den Serienkondensatoren C1, C2 je ein Serienwiderstand in dem symmetrischen Signalpfad vorgeschaltet, welche als R3, R4 bezeichnet sind. Parallel zu diesen Serienwiderständen R3, R4 ist je ein zweiter Schalter S3, S4 geschaltet. Die Schalterstellungen der Schalter S1 bis S4 sind in der vorliegenden Figur 5 im Normalbetrieb eingezeichnet.

Während eines Umschaltbetriebes wird zum einen, wie bereits bei Figur 1 erläutert, die höhere Grenzfrequenz des Hochpaßfilters durch Schließen der Schalter S1, S2 aktiviert, während zusätzlich das Tiefpaßfilter gebildet durch R3 mit C1 und R4 mit C2 durch Öffnen der Schalter S3, S4 aktiviert wird. Die genaue Schaltreihenfolge ist dabei zur Vermeidung des Sampling-Effekts so mit der Steuerschaltung, die die Schalter S1 bis S4 ansteuert, auszuführen, daß zum Umschalten von Normalbetrieb auf Umschaltbetrieb zunächst die Schalter S3, S4 geöffnet und anschließend die Schalter S1, S2 geschlossen werden. Bei der Rückkehr vom Umschaltbetrieb in den Normalbetrieb werden zur Vermeidung des Sampling-Effekts zunächst die Schalter S1, S2 wieder geöffnet und erst anschließend werden Schalter S3 und Schalter S4 geschlossen. Die Umladung der Kondensatoren C1, C2 erfolgt demnach während des Umschaltbetriebs mit der Zeitkonstanten gebildet aus dem Produkt von Widerstand und Kapazität, R3 * C1 beziehungsweise R4 * C2. Hierdurch ist sichergestellt, daß am Ausgang der Filteranordnung kein Sampling-Effekt auftritt, auch dann nicht, wenn das Nutzsignal nicht wesentlich kleiner als der durch das Umschalten der Verstärkung verursachte DC-Sprung ist.

Figur 6 zeigt am Ausgang einer Basisbandkette den Signalverlauf D bei Einsatz einer Schaltung gemäß Figur 5. Man erkennt, daß der Sampling-Effekt nicht mehr auftritt. Die noch erkennbaren Einschwingvorgänge während des Umschaltbetriebs werden durch das Kanalselektionsfilter, beziehungsweise das Basisbandfilter verursacht. Diese können beispielsweise durch Reduzierung der Verstärkung nach der Kanalselektion, das heißt mit dem dort üblichen programmierbaren Verstärker, deutlich reduziert werden oder durch Einfügen einer weiteren Wechselstrom-Kopplung in der Signalverarbeitungskette ausgeblendet werden.

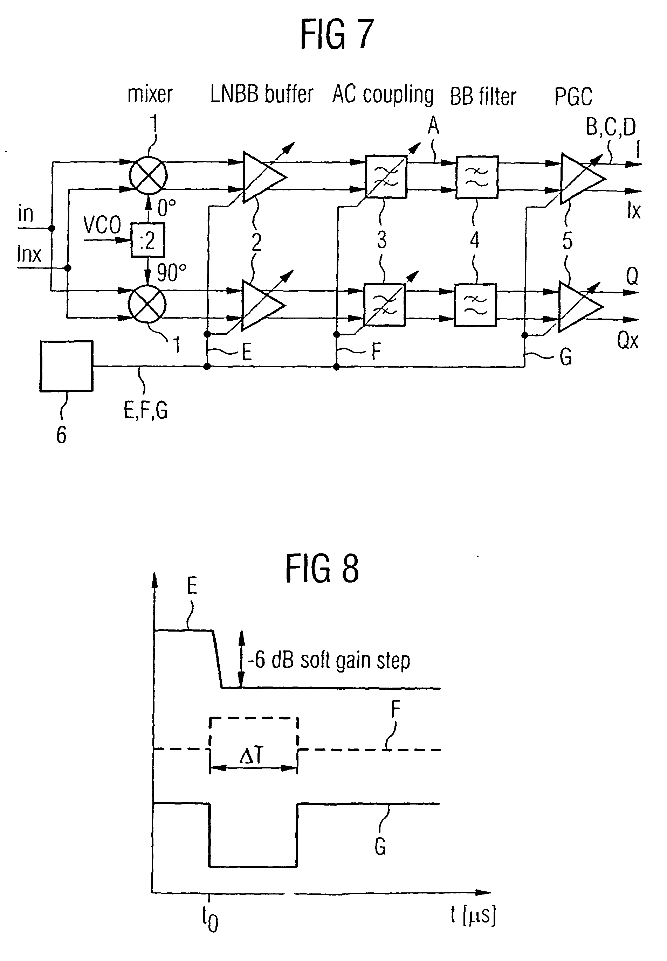

Figur 7 zeigt anhand eines beispielhaften, vereinfachten Blockschaltbildes eine homodyne Empfängeranordnung mit einer Wechselstrom-Kopplung, welche beispielsweise als Filteranordnung gemäß Figur 1 oder gemäß Figur 5 ausgebildet ist. Der Empfänger ist dabei als IQ-Empfänger zur Verarbeitung komplexwertiger Signale und zudem zum Führen der Inphase- und Quadratur-Komponenten jeweils als symmetrische Signale ausgebildet.

Im einzelnen ist ein IQ-Mischer zur Frequenzumsetzung 1 vorgesehen, dem ein empfangenes Hochfrequenzsignal an je einem Signaleingang je als symmetrisches Signal zuführbar ist. Die Mischer 1 weisen weiterhin je einen Lokaloszillatoreingang auf, dem ein Lokaloszillator-Signal zum einen unverändert und zum anderen mit einer Phasenverschiebung von 90° zugeführt ist. Ausgangsseitig an den Frequenzumsetzern 1 steht ein Basisbandsignal zur Verfügung, welches ebenfalls als symmetrisches Signal bereitgestellt ist. An die Ausgänge der Frequenzumsetzer 1 ist im Inphase- und im Quadraturpfad des Empfängers je ein rauscharmer Basisbandverstärker 2 mit einstellbarer Verstärkung angeschlossen. Ausgangsseitig am rauscharmen Basisbandverstärker 2 ist ein Hochpaßfilter mit einstellbarer Grenzfrequenz zur Wechselstrom-Kopplung angeschlossen. Am Ausgang der Hochpaßfilter 3 ist zur Kanalselektion je ein Basisbandfilter 4 angekoppelt, an dessen Ausgang wiederum ein programmierbarer Verstärker, englisch PGC, Programmable Gain Control 5, angeschlossen ist. Ausgangsseitig an den programmierbaren Verstärkern, das heißt am Ausgang der erläuterten Basisband-Signalverarbeitungskette, steht ein gefiltertes und verstärktes Basisbandsignal als komplexwertiges Signal, zerlegt in Inphase- und Quadraturkomponente I, Q bereit, wobei I- und Q-Komponenten jeweils als symmetrische Signale geführt sind.

Die rauscharmen Basisbandverstärker 2, die Filteranordnungen 3 sowie die programmierbaren Verstärker 5 weisen jeweils einen Steuereingang auf, der mit einer Steuerschaltung 6 verbunden ist. Das Signal zum Steuern der Verstärkung des rauscharmen Basisband-Puffers 2 ist mit E bezeichnet, das Signal zum Einstellen der gewünschten Grenzfrequenz des Hochpaßfilters 3 mit F und das Signal zum Einstellen der Verstärkung des programmierbaren Verstärkers 5, insbesondere dessen minimal einstellbarer Verstärkung, ist mit G bezeichnet.

Die Funktionsweise der Schaltung gemäß Figur 7, die zum Empfang von mit Code-Vielfachzugriffsverfahren codierten Signalen geeignet ist und demnach für UMTS-Empfänger anwendbar ist, wird anhand der Signalverläufe der Steuersignale E, F, G gemäß Figur 8 deutlich.

Figur 8 zeigt den Signalverlauf des Steuersignals E des rauscharmen Basisband-Verstärkers 2, der zum Zeitpunkt TO aufgrund geänderter Empfangsverhältnisse, beispielsweise einer größeren Empfangsfeldstärke, eine Verringerung der Verstärkung um 6 dB vornimmt. Die -6 dB-Stufe weist dabei einen weichen Übergang der Verstärkung auf. Zugleich mit der Änderung der Verstärkung wird für eine einstellbare Zeitspanne ΔT in der Filteranordnung 3 auf eine höhere Grenzfrequenz umgeschaltet, das heißt die Hochpaßfilter der Filteranordnungen 3 gehen beginnend mit dem Zeitpunkt T₀ und für die Zeitdauer ΔT vom Normalbetrieb in den Umschaltbetrieb über. Ist die Filteranordnung gemäß Figur 3 zusätzlich mit einer Tiefpaßfiltereigenschaft gemäß Figur 5 ausgebildet, so wird für die Zeitdauer ΔT dieses Tiefpaßfilter dem Hochpaß vorgeschaltet. Ebenfalls während der Zeitdauer ΔT und beginnend mit dem Zeitpunkt T₀ wird der programmierbare Verstärker 5 am Ende der Basisband-Signalverarbeitungskette mit dem Steuersignal G auf seine minimal einstellbare Verstärkung geschaltet, um einen immer unvermeidlichen Schalttransienten, selbst wenn dieser sehr gering ist, nicht weiter zu verstärken.

Die Kombination der beschleunigten Wechselstrom-Kopplung mit der höheren Grenzfrequenz, der weichen Umschaltung der Verstärkung gemäß Signal E, und die Abschaltung der nachfolgenden Verstärkerstufe 5 für die nun kurze Einschwingzeit ΔT des beschleunigten Hochpasses gemäß Steuersignal G bewirkt die beschriebenen Vorteile, nämlich niedrige Grenzfrequenz im Normalbetrieb des Hochpasses 3, geringe Einschwingzeit nach Änderung der Verstärkung, vernachlässigbar kleine Transienten zu den Umschaltzeitpunkten der Verstärkung des Verstärkers 2, optimale Aussteuerbarkeit nachgeschalteter Analog-/Digital-Konverter mit dem Nutzsignal und damit Realisierung mit wenigen Bits sowie Umschaltbarkeit der Verstärkung des Verstärkers 2 während des normalen Empfangbetriebs.

Anstelle der beschriebenen Zurückschaltung der Verstärkung nachgeschalteter Verstärker 5 gemäß Steuersignal G können in alternativen Realisierungen auch weitere Wechselstrom-Kopplungen in die Basisbandkette eingefügt werden.

### Bezugszeichenliste

- 1: Frequenzumsetzer
- 2: rauscharmer Basisbandverstärker
- 3: AC-Kopplung
- 4: Kanalfilter
- 5: PGC
- 6: Steuerschaltung
- A: Transiente
- B: Sprungantwort
- C: Sampling-Effekt
- D: Signalverlauf
- E: Steuersignal
- F: Steuersignal
- G: Steuersignal
- C1: Kondensator
- C2: Kondensator
- R1: Widerstand
- R2: Widerstand
- R3: Widerstand
- R4: Widerstand
- S1: Schalter
- S2: Schalter
- S3: Schalter
- S4: Schalter
- to: Beginn Umschaltbetrieb
- ΔT: Intervall Umschaltbetrieb

## Patentansprüche

1. Empfängeranordnung mit Wechselstrom-Kopplung, umfassend
- einen Eingang zum Zuführen eines Hochfrequenzsignals,
- einen Frequenzumsetzer (1), der mit dem Eingang gekoppelt ist und an seinem Ausgang ein Basisbandsignal bereitstellt,
- einen Basisband-Verstärker (2) mit einstellbarer Verstärkung, der am Ausgang des Frequenzumsetzers (1) angeschlossen ist und einen Steuereingang zum Einstellen der Verstärkung hat, **dadurch gekennzeichnet, dass**
- eine Filteranordnung (3) zur Wechselstrom-Kopplung vorgesehen ist, mit einem Eingang, der an einen Ausgang des Basisband-Verstärkers (2) angeschlossen ist und mit einem Hochpaßfilter (R1, R2, C1, C2) zur Filterung des Hasisband-Signals mit einer zwischen zumindest zwei Werten umschaltbaren Grenzfrequenz, wobei in einem Normalbetrieb die geringere und in einem Umschaltbetrieb die höhere der zumindest zwei Grenzfrequenzen wirksam ist, und mit einem Steuereingang zum Einstellen der Grenzfrequenz, und
- eine Steuerschaltung (6) zum Aktivieren der höheren Grenzfrequenz während des Umschaltbetriebes aufgrund einer Nachführung der Verstärkung des Basisband-Verstärkers (2) an die Empfangsbedingungen, mit einem Ausgang, der mit den Steuereingängen des Basisband-Verstärkers (2) und der Filteranordnung (3) verbunden ist.

2. Empfängeranordnung nach Anspruch 1,
**dadurch gekennzeichnet, daß**
die Steuerschaltung (6) so ausgebildet ist, daß das Aktivieren der höheren Grenzfrequenz im Hochpaßfilter der Filteranordnung (3) während eines einstellbaren Zeitintervalls (ΔT) erfolgt, welches zum Zeitpunkt (t₀) des Veränderns der Verstärkung des Basisband-Verstärkers (2) aufgrund der Nachführung der Verstärkung beginnt.

3. Empfängeranordnung nach Anspruch 1 oder 2,
**dadurch gekennzeichnet, daß**
die höhere Grenzfrequenz größer oder gleich 1 Megahertz beträgt.

4. Empfängeranordnung nach einem der Ansprüche 1 bis 3,
**dadurch gekennzeichnet, daß**
die Filteranordnung (3) ein zuschaltbares Tiefpaßfilter (R3, R4, C1, C2) umfaßt, welches mit der Steuerschaltung (6) zum Aktivieren der Tiefpaßwirkung während des Umschaltbetriebs gekoppelt ist.

5. Empfängeranordnung nach einem der Ansprüche 1 bis 4,
**dadurch gekennzeichnet, daß**
ein programmierbarer Verstärker (5) vorgesehen ist, der mit dem Ausgang des Filteranordnung (3) gekoppelt und an die Steuerschaltung (6) angeschlossen ist, zum Einstellen der kleinsten einstellbaren Verstärkung des programmierbaren Verstärkers (5) während des Umschaltbetriebes.

6. Empfängeranordnung nach Anspruch 5,
**dadurch gekennzeichnet, daß**
ein Basisbandfilter (4) zur Kanalselektion vorgesehen ist, welches zwischen Filteranordnung (3) und programmierbaren Verstärker (5) geschaltet ist.

7. Empfängeranordnung nach einem der Ansprüche 1 bis 6,
**dadurch gekennzeichnet, daß**
die Empfängeranordnung zur Verarbeitung symmetrischer Signale ausgelegt ist.

8. Empfängeranordnung nach einem der Ansprüche 1 bis 7,
**dadurch gekennzeichnet, daß**
das Hochpaßfilter der Filteranordnung (3) einen Querzweig in einem symmetrischen Signalpfad umfaßt, der einen Querwiderstand (R1) mit parallelgeschaltetem ersten Schalter (S1) aufweist, und daß dem Querzweig je ein Längszweig vorgeschaltet ist, der je eine Kapazität (C1, C2) umfaßt.

9. Empfängeranordnung nach Anspruch 8,
**dadurch gekennzeichnet, daß**
die Längszweige des symmetrischen Signalpfads der Filteranordnung (3) zur Bildung eines Tiefpasses je eine Parallelschaltung aus einem Widerstand (R3, R4) und einem zweiten Schalter (S3, S4) umfassen, die jeweils den Kapazitäten (C1, C2) vorgeschaltet sind.

10. Empfängeranordnung nach Anspruch 9,
**dadurch gekennzeichnet, daß**
die Steuerschaltung (6) derart ausgebildet ist, daß zum Aktivieren des Umschaltbetriebes zunächst die zweiten Schalter (S3, S4) geöffnet und anschließend die ersten Schalter (S1, S2) geschlossen werden und daß zur Rückkehr in den Normalbetrieb zunächst die ersten Schalter (S1, S2) geöffnet und anschließend die zweiten Schalter (S3, S4) geschlossen werden.

## Claims

1. Receiver arrangement with AC coupling, comprising
- an input for supplying a radio-frequency signal,
- a frequency converter (1) which is coupled to the input and produces a baseband signal at its output,
- a baseband amplifier (2) with variable gain, which is connected to the output of the frequency converter (1) and has a control input for varying the gain;
**characterized in that**
- a filter arrangement (3) for AC coupling is provided, with an input which is connected to an output of the baseband amplifier (2) and with a high-pass filter (R1, R2, C1, C2) for filtering the baseband signal, with a cut-off frequency which can be switched between at least two values, with the lower of the at least two cut-off frequencies being used in a normal mode and with the higher of the at least two cut-off frequencies being used in a changeover mode, and with a control input for varying the cut-off frequency, and
- a control circuit (6) for activation of the higher cut-off frequency during the changeover mode on the basis of a readjustment of the gain of the baseband amplifier (2) to the reception conditions, with an output which is connected to the control inputs of the baseband amplifier (2) and of the filter arrangement (3).

2. Receiver arrangement according to Claim 1,
**characterized in that**
the control circuit (6) is designed such that the higher cut-off frequency is activated in the high-pass filter of the filter arrangement (3) during a variable time interval (ΔT), which starts at the time (to) of the change to the gain of the baseband amplifier (2) on the basis of the readjustment of the gain.

3. Receiver arrangement according to Claim 1 or 2,
**characterized in that**
the higher cut-off frequency is greater than or equal to 1 Megahertz.

4. Receiver arrangement according to one of Claims 1 to 3,
**characterized in that**
the filter arrangement (3) comprises a low-pass filter (R3, R4, C1, C2) which can be connected and is coupled to the control circuit (6) in order to activate the low-pass filter effect during the changeover mode.

5. Receiver arrangement according to one of Claims 1 to 4,
**characterized in that**
a programmable amplifier (5) is provided, is coupled to the output of the filter arrangement (3) and is connected to the control circuit (6), in order to set the lowest gain which can be set for the programmable amplifier (5) during the changeover mode.

6. Receiver arrangement according to Claim 5,
**characterized in that**
a baseband filter (4) is provided for channel selection and is connected between the filter arrangement (3) and the programmable amplifier (5).

7. Receiver arrangement according to one of Claims 1 to 6,
**characterized in that**
the receiver arrangement is designed for processing balanced signals.

8. Receiver arrangement according to one of Claims 1 to 7,
**characterized in that**
the high-pass filter in the filter arrangement (3) comprises a parallel branch in a balanced signal path, which has a parallel resistor (R1) with a parallel-connected first switch (S1), and **in that** a series branch is in each case connected upstream of the parallel branch and in each case comprises a capacitance (C1, C2).

9. Receiver arrangement according to Claim 8,
**characterized in that**
the series branches of the balanced signal path in the filter arrangement (3) each comprise a parallel circuit formed by a resistor (R3, R4) and a second switch (S3, S4) in order to form a low-pass filter, and these are in each case connected upstream of the capacitances (C1, C2).

10. Receiver arrangement according to Claim 9,
**characterized in that**
the control circuit (6) is designed such that in order to activate the changeover mode, the second switches (S3, S4) are first of all opened and the first switches (S1, S2) are then closed, and **in that**, in order to return to the normal mode, the first switches (S1, S2) are first of all opened, and the second switches (S3, S4) are then closed.

## Revendications

1. Dispositif récepteur avec couplage en courant alternatif, comprenant :
- une entrée pour l'amenée d'un signal à haute fréquence,
- un convertisseur de fréquence (1) qui est couplé à l'entrée et qui fournit à sa sortie un signal en bande de base,
- un amplificateur en bande de base (2) avec amplification réglable, qui est raccordé à la sortie du convertisseur de fréquence (1) et qui a une entrée de commande pour le réglage de l'amplification,
**caractérisé par le fait qu'**il est prévu
- un dispositif de filtrage (3) pour le couplage en courant alternatif, avec une entrée qui est raccordée à une sortie de l'amplificateur en bande de base (2) et avec un filtre passe-haut (R1, R2, C1, C2) pour le filtrage du signal en bande de base avec une fréquence de coupure commutable entre au moins deux valeurs, la plus petite des au moins deux fréquences de coupure étant active lors du fonctionnement en mode normal et la plus grande étant active lors du fonctionnement en mode commutation, et avec une entrée de commande pour le réglage de la fréquence de coupure, et
- un circuit de commande (6) pour l'activation de la fréquence de coupure supérieure pendant le fonctionnement en mode commutation en raison du fait que l'amplification de l'amplificateur en bande de base (2) s'adapte aux conditions de réception, avec une sortie qui est reliée aux entrées de commande de l'amplificateur en bande de base (2) et du dispositif de filtrage (3).

2. Dispositif récepteur selon la revendication 1,
**caractérisé par le fait que** le circuit de commande (6) est conçu de telle sorte que l'activation de la fréquence de coupure supérieure dans le filtre passe-haut du dispositif de filtrage (3) s'effectue pendant un intervalle de temps réglable (ΔT) qui commence à l'instant (t₀) de la modification de l'amplification de l'amplificateur en bande de base (2) en raison de l'adaptation de l'amplification.

3. Dispositif récepteur selon la revendication 1 ou 2,
**caractérisé par le fait que** la fréquence de coupure supérieure est supérieure ou égale à 1 MHz.

4. Dispositif récepteur selon l'une des revendications 1 à 3,
**caractérisé par le fait que** le dispositif de filtrage (3) comprend un filtre passe-bas (R3, R4, C1, C2) qui peut être mis en circuit et qui est couplé au circuit de commande (6) pour l'activation de l'action passe-bas pendant le fonctionnement en mode commutation.

5. Dispositif récepteur selon l'une des revendications 1 à 4,
**caractérisé par le fait qu'**il est prévu un amplificateur programmable (5) qui est couplé à la sortie du dispositif de filtrage (3) et qui est raccordé au circuit de commande (6) pour le réglage de la plus petite amplification réglable de l'amplificateur programmable (5) pendant le fonctionnement en mode commutation.

6. Dispositif récepteur selon la revendication 5,
**caractérisé par le fait qu'**il est prévu un filtre en bande de base (4) pour la sélection de canal qui est branché entre le dispositif de filtrage (3) et l'amplificateur programmable (5).

7. Dispositif récepteur selon l'une des revendications 1 à 6,
**caractérisé par le fait que** le dispositif récepteur est conçu pour le traitement de signaux symétriques.

8. Dispositif récepteur selon l'une des revendications 1 à 7,
**caractérisé par le fait que** le filtre passe-haut du dispositif de filtrage (3) comprend dans un trajet de signal symétrique une branche en dérivation qui comporte une résistance inductive (R1) avec un premier interrupteur (S1) monté en parallèle et qu'une branche comprenant à chaque fois une capacité (C1, C2) est montée à chaque fois du côté amont de la branche en dérivation.

9. Dispositif récepteur selon la revendication 8,
**caractérisé par le fait que** les branches du trajet de signal symétrique du dispositif de filtrage (3) comprennent pour la formation d'un passe-bas à chaque fois un montage parallèle composé d'une résistance (R3, R4) et d'un deuxième interrupteur (S3, S4), lesquels montages parallèles sont branchés à chaque fois du côté amont des capacités (C1, C2).

10. Dispositif récepteur selon la revendication 9,
**caractérisé par le fait que** le circuit de commande (6) est conçu de telle sorte que, pour l'activation du fonctionnement en mode commutation, les deuxièmes interrupteurs (S3, S4) sont d'abord ouverts et les premiers interrupteurs (S1, S2) sont ensuite fermés et que, pour le retour dans le fonctionnement en mode normal, les premiers interrupteurs (S1, S2) sont d'abord ouverts et les deuxièmes interrupteurs (S3, S4) sont ensuite fermés.
